# EUROPEAN PATENT APPLICATION

(11) **EP 4 380 322 A1**
(43) Date of publication of application: **05.06.2024**
(21) Application number: 23386006.3
(22) Date of filing: 31.01.2023
(51) Int. Cl.: H05K 1/02, H05K 3/12, H05K 3/34, B23K 3/06, H05K 3/00

(54) **PATTERN RECOGNITION SYSTEM AND METHOD FOR DIGITAL PRINTED CIRCUIT BOARD ASSEMBLY**

(30) Priority: 30.11.2022 GR 20220100986
(71) Applicant: Prisma Ilektronika A.V.E.E. With d.t. "Prisma Electronics S.A.", 68132 Alexandroupoli (GR); National Technical University of Athens, 15780 Zografou (GR)
(72) Inventor: Giordamlis, Christos, 68132 Alexandroupoli (GR); Zergioti, Ioanna, 15669 Papagou (GR); Makrygianni, Marina, 15233 Chalandri (GR); Zaharatos, Filimon, 11141 Athens (GR); Theodorakos, Ioannis, 15344 Gerakas (GR)

(57) **Abstract**

The invention relates to a method for pattern recognition to assemble printed circuit boards by digital printing and a system for implementing the method. In the method, pattern recognition methods are applied to extract information from the imaging of the printed circuit board, thereby automating the printing of the targeted object on the board. The method consists of the digital printing of a material that is uniformly coated on a transparent donor substrate and placed in parallel to a receiver substrate. A laser pulse irradiates the donor substrate resulting in the detachment and printing of part of the material on the receiver. This particular method allows to minimize the time of the overall process, with high alignment accuracy and high printing resolution.

## Description

### THE RELEVANT TECHNOLOGICAL FIELD

The invention refers to the field of electricity and more specifically to the field of printed circuits, compartments or components of electrical devices and the manufacturing of assembled parts. It further refers to the field of physics and measuring instruments in general and in particular to the field of measurements and tests. Even more specifically, it refers to the field of research and analysis of materials, determining their physical or chemical properties. It also refers to the fields of radiation analysis of materials, mass spectrometry, and the determination of the presence, intensity, density, or energy of radiation or particles. It specifically refers to a pattern recognition system and method for the assembly of printed circuit boards by digital printing.

### PRIOR ART OF THE INVENTION

The method and pattern recognition system disclosed in the present invention for assembling printed circuit boards by digital printing, have not been disclosed in the prior art.

Surface Mount Technology (SMT - Surface-Mount Technology) is a technology for assembling and bonding SMD (Surface Mounted Device) components, such as resistors, capacitors, transistors, integrated circuits on a printed circuit board (PCB - Printed Circuit Board), through a process of annealing the adhesive material (reflow soldering). SMD components are also referred to as chip components.

By reducing the dimensions of the components, the SMT technology presents some limitations, such as indicative and non-limiting, listed below. Stencil printing used to deposit solder paste is responsible for most PCB assembly defects. Parameters that limit assembly are variations in printed adhesive paste volumes, as well as misalignment. In addition, using mask printing, the processing of small-sized components for high assembly density (ultra-fine pitch components) is quite limited, while it is not possible to process ultrathin components (thickness < 50µm) attached to flexible substrates. Furthermore, there is a limitation in dimensions, in cases below 200 µm, the assembly of parts with a significant height mismatch is not possible, as well as edge coupling or vertical connection. Another existing disadvantage is that there is no visual control in real time of the printing of the adhesive paste on the PCB board. Finally, SMT PCB prototyping or low-volume production is expensive and often unprofitable.

It is thus an objective of the present invention to reduce and improve the above disadvantages described in the current state of the art and to provide a system and method for assembling PCB boards by digital printing.

A further objective of the present invention is to offer partial automation of the targeting/printing process with high accuracy and speed, by finding special fiducials, using a high resolution camera and software with pattern recognition algorithms.

It is a further objective of the present invention to help eliminate the need for precision in the physical placement of the PCB board in terms of its orientation during printing.

These and other objectives, features and advantages of the invention will become apparent in the following detailed description.

### BRIEF DESCRIPTION OF THE DRAWINGS

The invention will become apparent to those skilled in the art by reference to the accompanying drawings in which it is illustrated in an illustrative non-limiting manner.
Figure 1 shows the logic diagram of the pattern recognition method for assembling printed circuit boards by digital printing, in accordance with what is presented in the present invention.
Figure 2 shows an illustration of the micromachining device of the present invention.

### DETAILED DESCRIPTION OF THE HIGHLIGHTED APPLICATION

Referring now to the accompanying drawings we will describe exemplary embodiments of both the method and the pattern recognition system for digitally printed circuit board assembly used in said method. Laser printing is a direct printing technique with the possibility of depositing materials in liquid or solid phase. The basic steps of the technique are summarized as follows: (i) the material to be printed is uniformly coated on a transparent, with respect to the laser radiation wavelength, donor substrate and placed in parallel, in close proximity to an acceptor substrate, (ii) A laser pulse of a specific energy irradiates the transparent substrate/material to be printed resulting in the detachment and printing of part of the material on the receiver. The laser printing technique offers the possibility to print small volume structures, with fast printing speed and high accuracy in terms of quantity control. Laser printing technology is a flexible, high-quality, efficient and cost-effective process for interconnecting small and very small electronic components with a resolution of less than 100 µm, in electronic applications. In particular, it provides the possibility to print a small amount of adhesive paste on the PCB board with a high printing rate (> 10,000 contacts per second) and high precision for quantity control. Direct printing of the solder paste onto the PCB board and the subsequent interconnection of electronic components, thus skipping the expensive step of placing solder paste beads at the wafer-level, simplifies and reduces the cost of the assembly process. In addition, the additive nature of the process allows for one-step fabrication, thereby limiting the consumption and disposal of functional materials. By using this technique, the steps in the industrial IC assembly process are significantly reduced, as the mask design and fabrication step is bypassed.

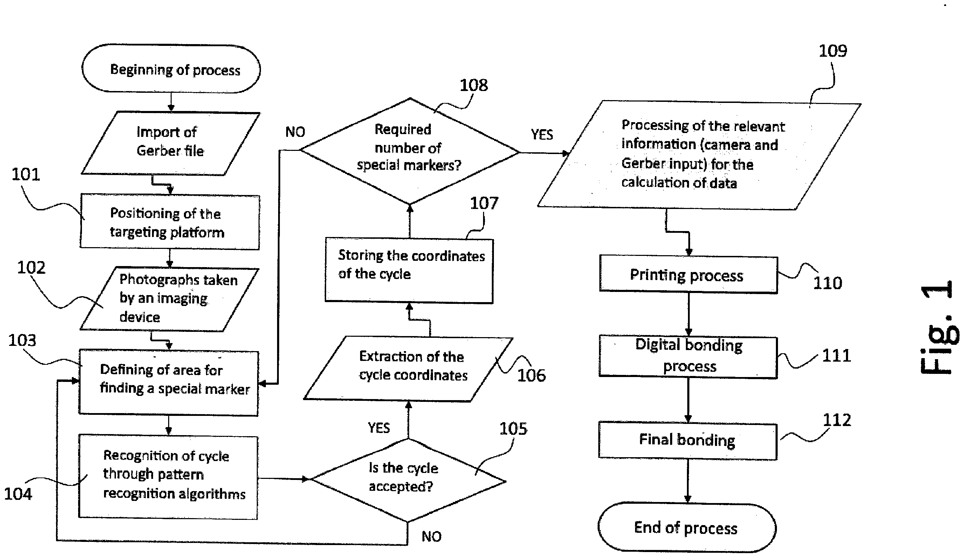

The steps followed to implement the method initially require fixing the printed circuit board (PCB) to a predetermined point on the system's target platform and physically constraining the board with appropriately shaped pins, which demarcate its outer limit positions. Using micromechanics, the position of the targeting platform is adjusted relative to the laser source (101), Fig. 1. Photographs of the printed circuit board to be assembled are then taken using an imaging device (102). The printed circuit board assembly data is entered into system control software. The purpose of the input is to extract the information regarding the coordinates, shape and area of the areas of the printed circuit, where adhesive paste will be deposited. After the board is fixed in the assembly, its image is taken, through a high-resolution camera, to start the process of detecting and finding the required fiducials, extracting the necessary data and continuing with the printing process.

Recognition and identification of specific markers on printed circuit board photographs requires the application of pattern recognition methods based on printed circuit board industry design and manufacturing standards (103-104). To detect and analyze a shape present in an image, the pixels of the image should be checked, as these will be used as the input information for the shape analysis process, based on the relevant algorithms. In the first phase, it should be confirmed that the objects in the image, that are possible shapes to be searched, for are in an image with a black background and are of a different color. In case the depth of the image is not black, the image should be converted accordingly. As the special markers are circular shapes, only the circles (104) should be detected in this particular procedure. The idea of the circle detection algorithm is based on the assumption that all edges of the shape have the same distance from its center (ideal circle), which is equal to the radius of the circle. However, it is possible for a circular shape to have some distortion, so some pixels of the image located on the perimeter of the circle are somewhat closer or further away from its center (non-ideal circle). This variation in the distance from the center should not be too large and should be within certain acceptable limits, since if they are too large, then the object under examination is probably not in the shape of a circle. For a given set of pixels of the perimeter of a circle it is easy to estimate its center and radius by finding the bounding rectangle. Once the radius and center of the circle are calculated, then all that is needed is to calculate the distance of the perimeter pixels from the estimated center and check the difference with the estimated radius. Instead of checking each individual distance value for each pixel of the perimeter, one can simply calculate the average distance and then check whether the value falls within a certain range or not. Ideally each value should tend to zero, which means that all points on the perimeter fit within the estimated circle. Otherwise, a shape distortion level should be allowed, which should depend on its size, allowing a higher distortion level for larger shapes and a lower distortion level for smaller shapes. The above procedures are performed automatically by the relevant software that implements the specific steps of the method. To minimize the time of the overall process, as well as errors, due to the large size of the image and the number of elements in total, and to start the process of finding a special marker, which is required in one of the steps of the method, the user should define a specific area of the image by marking it (103). So based on the process of detecting and finding circular shapes, the steps performed algorithmically to detect and find the special markers in the region of the received image of a board are as follows: The identification of the special markers involves converting the image to black and white, so that the special markers, i.e. the circles that are desired to be detected, are displayed in white on a black background or vice versa. Then the detected elements are counted and their number is measured, in order to extract the relevant list. The set of detected elements is re-processed, in which each of them is checked, with shape detection algorithms, to see if any of them match some type of simple geometric shape. Essentially, the edge pixels of each object are checked to see if they meet certain criteria, so that the objects are classified into known shapes. The set of known shapes detected is subjected to a final check as to whether each of them belongs to the circle class (104). At the end, all the cycles are presented in order to decide whether some or all of them are accepted by the user (105).

In the next step of the method, the position and orientation of the physical object to be targeted on the platform is recognized and the transformation of the three coordinate systems (106) is extracted, at which point the user defines which of the three required special indicators is to be the coordinates of its position (107) are stored. The cycle detection process above is repeated until the required number of three specific markers (108) are filled. The three systems involve the printed circuit board design, the targeting system, and the actual physical object on the targeting platform (109).

The donor substrate is then positioned and aligned, using the controlled X-Y movement of the system's stepper motors, coating - covering the donor with a thin layer (10-150 µm thick) of adhesive paste (110) and the digital bonding process follows, using printing with laser (111). The next steps involve placing the printed circuit board to be assembled in a component placement machine and depositing the components in their predetermined positions, followed by placing the printed circuit board to be assembled in a thermal annealing machine for the achievement of the final bonding (112). Finally, visual and sample inspections will follow to certify proper operation.

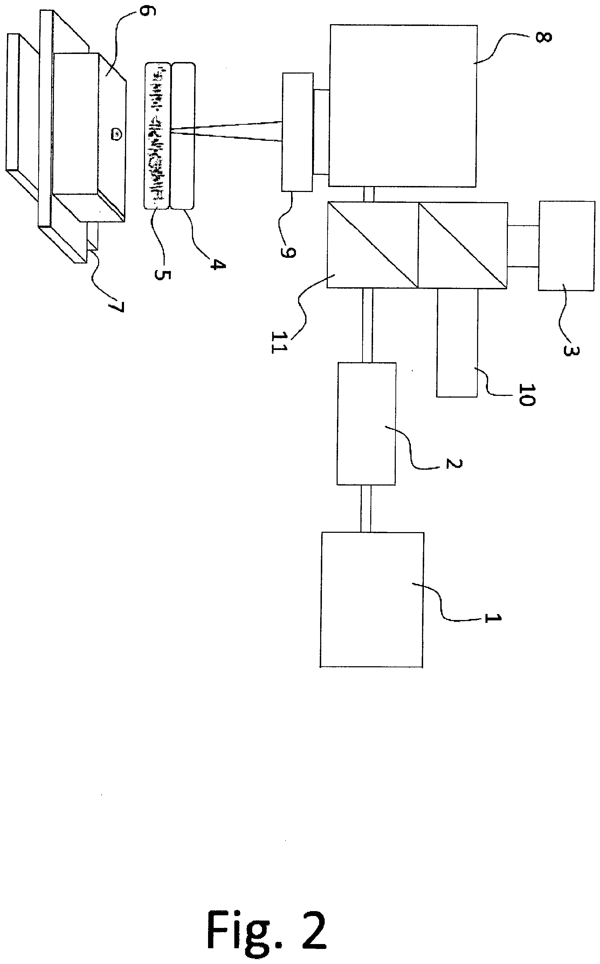

The system for pattern recognition for the assembly of printed circuit boards by digital printing, according to the invention, consists of a laser micro-processing station, Fig. 2, that comprises a pulsed laser source (1), a laser scanning system, an optical path (2), consisting of optical parts, such as lenses and mirrors, but also a controllable arrangement for the X-Y movement of donor/receiver substrates, via stepper motors. Furthermore, there is a base for the receiver substrate (6), i.e. a PCB board, with maximum indicative dimensions of 100 × 100 mm². The laser scanning system comprises a two-dimensional galvanometric system (8) and an F-theta (9). The optical path consists of guiding a laser beam through a series of mirrors (11), a two-lens arrangement, to magnify the laser beam to a size determined by the diameter of the entrance hole of the galvanometric system and to parallelize it before entering the two-dimensional galvanometric system and a beam attenuator arrangement. The controllable printing setup includes a transparent carrier coated with solder paste (4-5), a receiver substrate (6), a stepper motor with movement in the Z direction, and an adjustable XY translation stage configuration (7).

The system also includes an additional imaging setup to visualize in real time the experimental process, comprising a CMOS camera (3), combined with a series of optics, such as an achromatic lens, a dichroic mirror, placed inline with the laser beam propagation axis and illuminating the donor substrate via a LED source (10).

The system is controlled by a computer and a software specifically developed for this process. The software is responsible for configuring the system, controlling the electromechanical parts (stepper motors, galvanometric system) and supervising the solder paste printing process. Achieving µm-level accuracy in identifying and recognizing the location of fiducials on the board with pattern recognition is possible through the use of a high-resolution camera and image processing algorithms from machine learning programming libraries.

It should be noted here that the description of the invention was made with reference to illustrative application examples to which it is not limited. Likewise, any change or modification in terms of shape, dimensions, morphology, materials used and construction and assembly components, as long as they do not constitute a new inventive step and do not contribute to the technical development of what is already known, are considered included in the aims and objectives of the present invention as summarized in the following claims.

## Claims

1. Pattern recognition method for the assembly of printed circuit boards by digital printing, where a printed circuit board is fixed on a target board, a laser source is adjusted with respect to the target platform, pictures are captured via an imaging setup, of the printed circuit board to be assembled, the coordinates of the shape and areas of interest on the printed circuit board where the solder paste will be deposited, are extracted, special markers are located and identified on the captured pictures of the board, through pattern recognition methods, for the solder paste deposition, the position and orientation of the physical object to be targeted on the platform is identified, a donor substrate is placed and aligned, the donor is coated with a solder paste layer, digital soldering is achieved via laser printing, the printed circuit board to be assembled is placed in a component placement machine, the parts are deposited in predetermined positions and thermal annealing takes place for the final bonding.

2. Pattern recognition system for the assembly of printed circuit boards by digital printing, consisting of a pulsed laser source (1), an optical path (2), to guide the laser beam through a series of mirrors (11), a two-lens system setup, to magnify the laser beam to a size determined by the diameter of the entrance hole of the galvanometric system and to parallelize it, before entering the two-dimensional galvanometric system (8), an attenuating beam setup, of a controllable printing setup with a transparent carrier coated with solder paste (4-5), a receiver substrate (6), a stepper motor with movement in the Z direction and an adjustable XY translation stage configuration (7) and an imaging setup for real-time visualization, a CMOS camera (3), combined with an achromatic lens, a dichroic mirror, placed inline with the beam propagation axis (1), and a LED source illuminating the donor substrate (10).
